# EUROPEAN PATENT APPLICATION

(11) **EP 3 706 525 A2**
(43) Date of publication of application: **09.09.2020**
(21) Application number: 20160144.0
(22) Date of filing: 28.02.2020
(51) Int. Cl.: H05K 7/20, G02B 6/42

(54) **STANDARDIZED HOT-PLUGGABLE TRANSCEIVING UNIT WITH HEAT DISSIPATION CAPABILITIES**

(30) Priority: 05.03.2019 US 201916292443
(71) Applicant: Riedel Communcations Canada Inc., Montréal, Québec H3B 3V2 (CA)
(72) Inventor: LAVOIE, Renaud, Laval Québec H7Y2A7 (CA); DUDEMAINE, Eric, Crabtree Québec J0K1B0 (CA); VELLEE, Yannick, Saint-Calixte Québec J0K1Z0 (CA)
(74) Representative: Roche, von Westernhagen & Ehresmann

(57) **Abstract**

Transceiving unit with heat dissipation capabilities. The transceiving unit comprises a housing adapted to being inserted into a port of a hosting unit, the housing defining a top surface. The transceiving unit comprises a rear connector located on a back panel of the housing. The transceiving unit comprises at least one electronic component located inside the housing. The transceiving unit comprises an insert disposed along the top surface of the housing, the insert passively extracting heat generated by the at least one electronic component located inside the housing. Alternatively or complementarily to the insert, the transceiving unit comprises a heat sink integrated to a front panel of the housing for passively extracting heat generated by the at least one electronic component located inside the housing. In a particular aspect, the transceiving unit is a standardized hot-pluggable transceiving unit, the housing having standardized dimensions.

## Description

### TECHNICAL FIELD

The present disclosure relates to the field of standardized hot-pluggable transceiving units. More specifically, the present disclosure relates to a standardized hot-pluggable transceiving unit having heat dissipation capabilities.

### BACKGROUND

Small Form-factor Pluggable (SFP) units represent one example of standardized hot-pluggable transceiving units. SFP units are standardized units adapted to be inserted within a chassis of a hosting unit. A suite of specifications, produced by the SFF (Small Form Factor) Committee, describe the size of the SFP unit, so as to ensure that all SFP compliant units may be inserted smoothly within one same chassis, i.e. inside cages, ganged cages, superposed cages and belly-to-belly cages. Specifications for SFP units are available at the SFF Committee website.

SFP units may be used with various types of exterior connectors, such as coaxial connectors, optical connectors, RJ45 connectors and various other types of electrical connectors. In general, an SFP unit allows connection between an external apparatus, via a front connector of one of the aforementioned types, and internal components of a hosting unit, for example a motherboard, a card or a backplane leading to further components, via a back interface of the SFP unit. Specification no INF-8074i Rev 1.0, entitled "SFP (Small Form-factor Pluggable) Transceiver, dated May 12, 2001, generally describes sizes, mechanical interfaces, electrical interfaces and identification of SFP units.

The SFF Committee also produced specification no SFF-8431 Rev. 4.1, "Enhanced Small Form-factor Pluggable Module SFP+", dated July 6, 2010. This document, which reflects an evolution of the INF-8074i specification, defines, inter alia, high speed electrical interface specifications for 10 Gigabit per second SFP+ modules and hosts, and testing procedures. The term "SFP+" designates an evolution of SFP specifications.

INF-8074i and SFF-8431 do not generally address internal features and functions of SFP devices. In terms of internal features, they simply define identification information to describe SFP devices' capabilities, supported interfaces, manufacturer, and the like. As a result, conventional SFP devices merely provide connection means between external apparatuses and components of a hosting unit, the hosting unit in turn exchanging signals with external apparatuses via SFP devices.

Recently, SFP units with internal features and functions providing signal processing capabilities have appeared. For instance, some SFP units now include signal re-clocking, signal reshaping or reconditioning, signals combination or separation, signal monitoring, etc. Furthermore, some SFP units now include content processing capabilities, for processing the content transported by the signals received by the SFP units.

The integration of a larger number of electronic component within the housing of an SFP unit increases the global power consumption of the SFP unit, and accordingly the heat generated by the SFP unit. Therefore, it becomes practical and sometimes even mandatory to use heat dissipation means for extracting at least some of the generated heat from the SFP unit. A failure to perform heat dissipation may result in damaging some of the electronic component within the housing of the SFP unit, harming a person manipulating the SFP unit, etc.

Therefore, there is a need for a new standardized hot-pluggable transceiving unit having heat dissipation capabilities.

### SUMMARY

According to a first aspect, the present disclosure provides a transceiving unit. The transceiving unit comprises a housing adapted to being inserted into a port of a hosting unit, the housing defining a top surface. The transceiving unit comprises at least one electronic component located inside the housing. The transceiving unit comprises an insert disposed along the top surface of the housing, the insert passively extracting heat generated by the at least one electronic component located inside the housing. The transceiving unit comprises a rear connector located on a back panel of the housing.

According to a second aspect, the present disclosure provides transceiving unit. The transceiving unit comprises a housing adapted to being inserted into a port of a hosting unit, the housing comprising a front panel. The transceiving unit comprises a heat sink integrated to the front panel for passively extracting heat generated by the at least one electronic component located inside the housing. The transceiving unit comprises a rear connector located on a back panel of the housing.

In a particular aspect, the insert is made of copper, silver, graphite, gold, platinum, or an alloy of a combination thereof.

In another particular aspect, the transceiving unit is a standardized hot-pluggable transceiving unit and the housing has standardized dimensions.

According to an advantageous embodiment of the invention, the transceiving unit further comprises at least one front connector located on the front panel of the housing.

According to an advantageous embodiment of the invention, the transceiving unit, further comprises an active cooling device located inside the housing.

According to an advantageous embodiment of the invention, the active cooling device consists of a fan, a blower, a thermoelectric cooler or a heat pipe.

According to an advantageous embodiment of the invention, the active cooling device is located in the vicinity of a surface of the front panel internal to the housing.

According to an advantageous embodiment of the invention, the transceiving unit further comprises an insert disposed along a top surface of the housing, the insert passively extracting heat generated by the at least one electronic component located inside the housing.

### BRIEF DESCRIPTION OF THE DRAWINGS

Embodiments of the disclosure will be described by way of example only with reference to the accompanying drawings, in which:
- Figure 1: is a top view of an SFP unit;
- Figure 2: is a side elevation view of the SFP unit of Figure 1;
- Figure 3: is a front elevation view of the SFP unit of Figure 1;
- Figure 4: is back elevation view of the SFP unit of Figure 1;
- Figure 5: is a bottom view of the SFP unit of Figure 1;
- Figure 6: is a perspective view of the SFP unit of Figure 1;
- Figure 7: is a top view of the SFP unit of Figure 1 with an insert for passively extracting heat;
- Figure 8: is a perspective view of the SFP unit of Figure 6 with an insert for passively extracting heat;
- Figure 9: is a top view of the SFP unit of Figure 1 with an insert for passively extracting heat, and without front connectors;
- Figure 10: is a perspective view of the SFP unit of Figure 6 with an insert for passively extracting heat, and without front connectors;
- Figure 11: is a front elevation view of the SFP unit of Figure 3 with an integrated heat sink;
- Figures 12A and 12B: are side elevation views of the SFP unit of Figure 2 with an integrated heat sink;
- Figure 14: is a front elevation view of the SFP unit of Figure 3 with two integrated heat sinks; and
- Figures 15 and 16: are a side elevation views of the SFP unit of Figure 12A with an active cooling device in addition to the integrated heat sink.

### DETAILED DESCRIPTION

The foregoing and other features will become more apparent upon reading of the following non-restrictive description of illustrative embodiments thereof, given by way of example only with reference to the accompanying drawings.

The present disclosure describes standardized hot-pluggable transceiving units, such as Small Form-factor Pluggable (SFP) /SFP+ units, having internal features that far exceed those of conventional units. Conventional units merely provide connection capabilities between a hosting unit in which they are inserted and external apparatuses. The standardized hot-pluggable transceiving unit disclosed herein provides heat dissipation capabilities, in order to adapt to the heat generated by the power consumption of electronic component located within the housing of the transceiving unit.

The following terminology is used throughout the present disclosure:
- SFP:: Small Form-factor Pluggable, this term refers to units that are insertable into a chassis of a hosting unit; in the present disclosure, an SFP unit complies with an industry standard specification.
- Connector:: A device component for physically joining circuits carrying electrical, optical, radio-frequency, or like signals.

### STANDARDIZED HOT-PLUGGABLE TRANSCEIVING UNIT WITH CONVENTIONAL CAPABILITIES

In the rest of the disclosure, an SFP unit is used to illustrate an example of a standardized hot-pluggable transceiving unit. However, the teachings of the present disclosure are not limited to an SFP unit; but can be applied to any type of standardized hot-pluggable transceiving unit.

An SFP unit comprises a housing having a front panel, a back panel, a top, a bottom and two sides. Generally, the front panel includes at least one connector for connecting a cable, a fiber, twisted pairs, etc. The back panel includes at least one rear connector for connecting to a hosting unit. However, some SFP units may have no front connector, or alternatively no rear connector. The SFP unit may be fully-compliant or partially compliant with various SFP standards, such as SFP, SFP+, XFP (SFP with 10 Gigabit/s data rate), Xenpak, QSFP (Quad (4-channel) SFP with 4x1 Gigabit/s data rate), QSFP+ (Quad (4-channel) SFP with 4x10 Gigabit/s data rate), CFP (C form-factor pluggable with 100 Gigabit/s data rate), CPAK, SFP28 (SFP with 25 Gigabit/s data rate), SFP56 (SFP with 50 Gigabit/s data rate), SFP112 (SFP with 112 Gigabit/s data rate), QSFP28 (Quad (4-channel) SFP with 4x28 Gigabit/s data rate), QSFP56 (Quad (4-channel) SFP with 4x56 Gigabit/s data rate), QSFP112 (Quad (4-channel) SFP with 4x112 Gigabit/s data rate), or any other standardized Small Form-factor Pluggable unit.

In the rest of the description, when the terminology SFP unit is used, it may encompass any of the aforementioned standards when applicable.

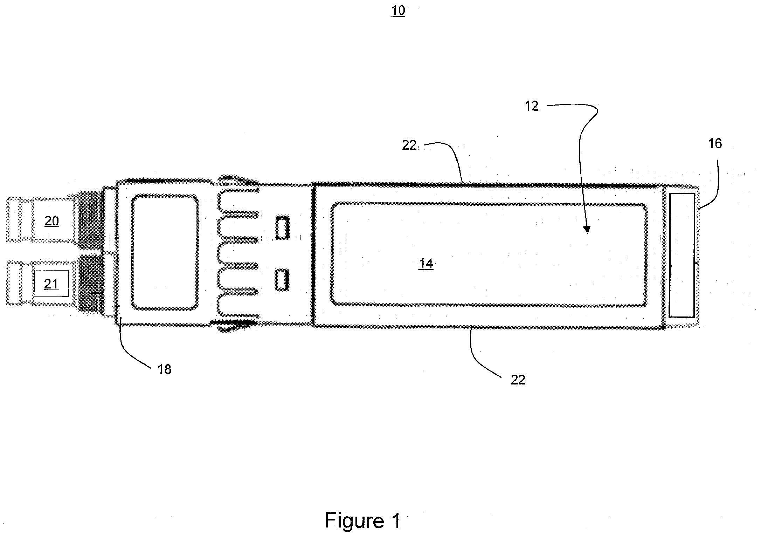

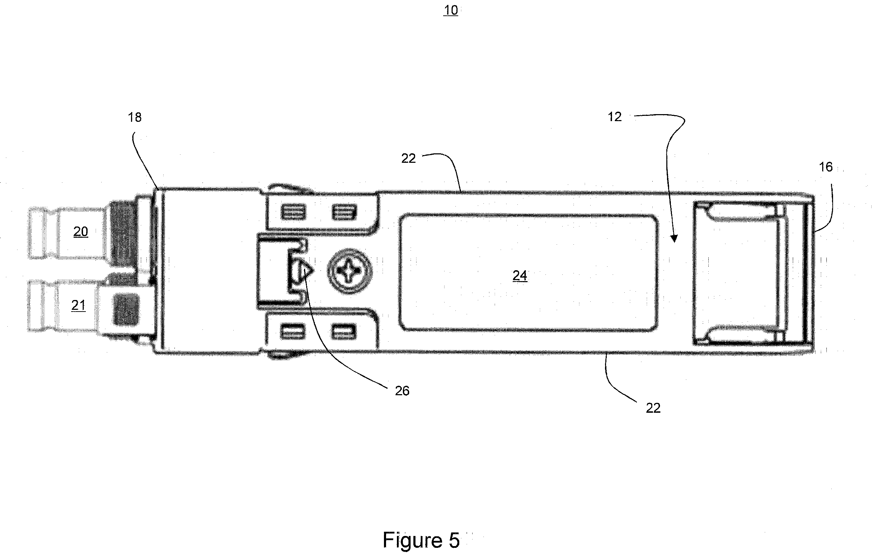

Reference is now made concurrently to Figures 1-6, which are, respectively, a top view, a side elevation view, a front elevation view, a back elevation view, a bottom view and a perspective view of an SFP unit 10. The SFP unit 10 comprises a housing 12. The housing defines a top 14, a bottom 24, and two sides 22. The housing 12 is at least partially of dimensions in compliance with at least one of the previously mentioned SFP standards. Alternatively, the housing 12 has functional dimensions based on at least one of the aforementioned SFP standards.

The SFP unit 10 further comprises a back panel 16 affixed to the housing 12. The back panel 16 comprises a rear connector 17, for instance an electrical or an optical connector. In an example, the back panel 16 comprises the rear connector 17 (also named a host connector) suitable to connect the SFP unit 10 to a backplane of a chassis (not shown for clarity purposes) of a hosting unit, as known to those skilled in the art. More specifically, the connection is performed via a port of the hosting unit adapted for insertion of the SFP unit 10 and connection of the rear connector 17 to the backplane of the hosting unit.

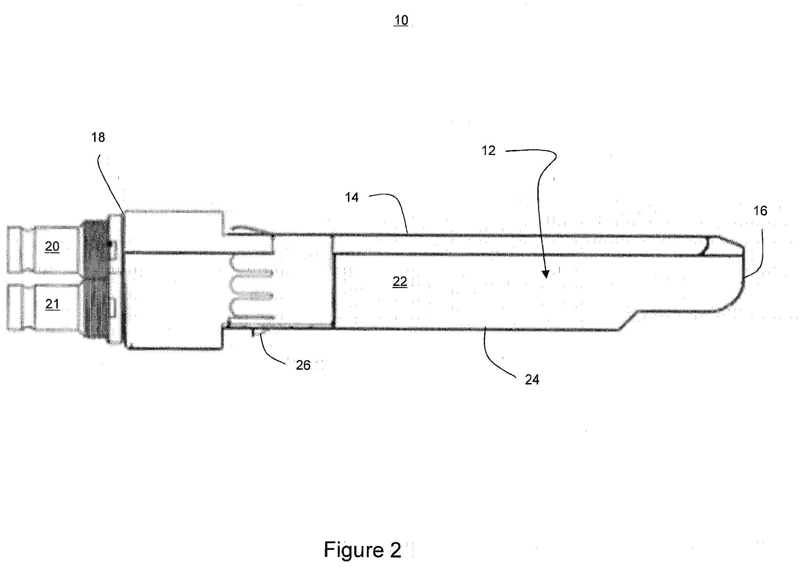

The SFP unit 10 further comprises a front panel 18 affixed to the housing 12. The front panel 18 comprises zero, one or more connector(s). For example, Figures 1-6 illustrate a front panel 18 with a connector 20 of a co-axial cable type (adapted to send and/or receive video IP flows) and a connector 21 (also of the co-axial cable type, also adapted to send and/or receive video IP flows). The SFP unit 10 further comprises an engagement mechanism, such as for example a latch 26 as shown in a resting position on the bottom 24 in Figure 2, for maintaining the SFP unit 10 in place within a chassis.

### TRANSCEIVING UNIT WITH A TOP INSERT FOR EXTRACTING HEAT

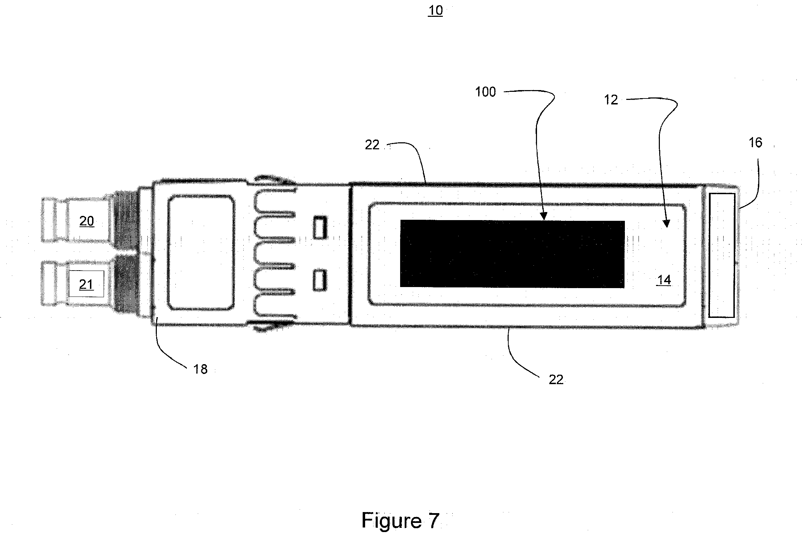

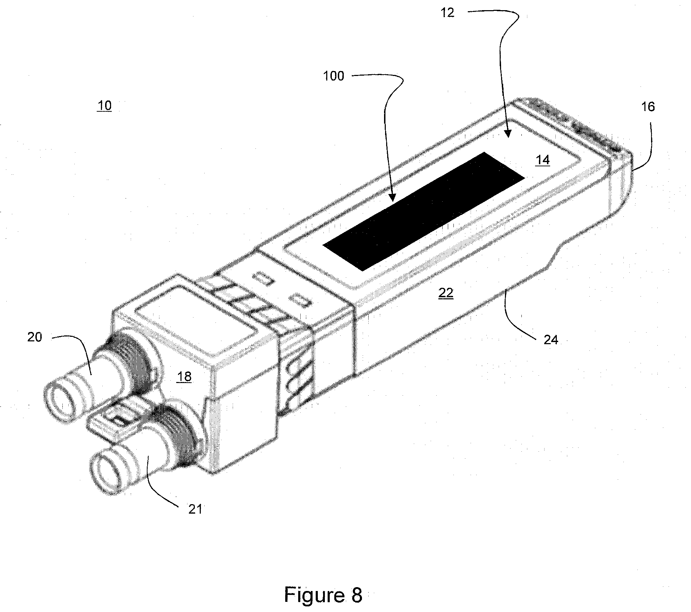

Referring now concurrently to Figures 7 and 8, the SFP unit 10 of Figures 1-6 is represented with an insert 100.

The insert 100 is disposed along the top surface 14 of the housing 12. The insert 100 is made of a material having the property of being an excellent heat conductor. For example, the insert 100 is made of copper, silver, graphite, gold, platinum, an alloy of at least two of these, etc. The role of the insert 100 is to extract heat generated by one or more electronic component located inside the housing 12.

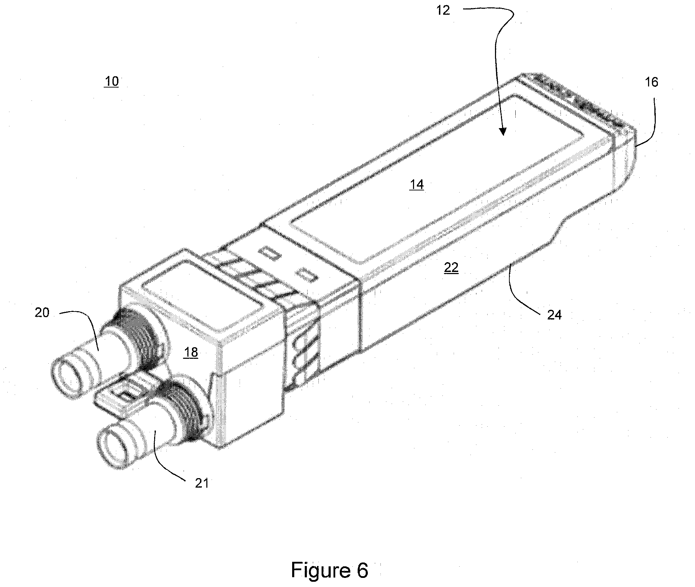

Figure 7 represents a top view of the SFP unit 10 with the insert 100, corresponding to Figure 1. Figure 8 represents a perspective view of the SFP unit 10 with the insert 100, corresponding to Figure 6.

In a first exemplary implementation, the insert 100 is integral to the top surface 14 of the housing 12. The housing 12 is made of a material different from the material of the insert 100. For example, the housing 12 is made of steel or aluminum. A portion of material having the shape of the insert 100 is extruded from the top surface 14 of the housing 12, and the insert 100 is positioned within the extruded portion of the top surface 14 of the housing 12. The thickness of the insert 100 may be lower than, equal to or greater than the thickness of the top surface 14 of the housing 12. The insert 100 is affixed to the top surface 14 of the housing 12 by means well known in the art (e.g. the insert 100 is welded to the top surface 14 of the housing 12, the insert 100 is held together with the top surface 14 of the housing 12 by fasteners or bonding, etc.). In a particular configuration, the original top surface 14 of the housing 12 is entirely replaced with the insert 100, so that the heat extraction capabilities are deployed on the entire top surface 14.

In a second exemplary implementation, the insert 100 is affixed above the top surface 14 of the housing 12. The insert 100 is positioned above a portion of the top surface 14 of the housing 12. The insert 100 is affixed to the top surface 14 of the housing 12 by means well known in the art (e.g. the insert 100 is welded above the top surface 14 of the housing 12, the insert 100 is held together with the top surface 14 of the housing 12 by fasteners or bonding, etc.). In a particular configuration, the top surface 14 of the housing 12 is entirely covered by the insert 100, so that the heat extraction capabilities are deployed on the entire top surface 14.

As mentioned previously, the SFP unit 10 includes one or more electronic component located inside the housing 12. The one or more electronic component generates heat within the housing 12, and at least part of the generated heat is passively extracted from the housing 12 by the insert 100. The extracted heat is released by the insert 100 outside the housing 12. Examples of electronic component include an optical to electrical signal converter, an electrical to optical signal converter, a signal re-clocking unit, a signal processing unit, a data processing unit adapted for processing data transported by a signal, etc. The signal or data processing unit may consist of processor(s), Field-Programmable Gate Arrays (FPGA), Application-Specific Integrated Circuit (ASIC), etc.

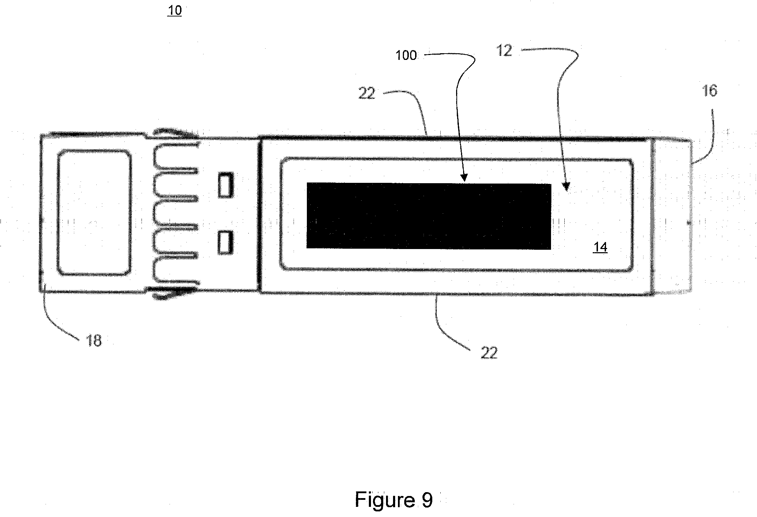

Figures 7 and 8 illustrate the SFP unit 10 comprising the rear connector 17 and at least one front connector (e.g. 20 and 21). However, in a different configuration represented in Figures 9 (top view) and 10 (perspective view), the SFP unit 10 comprises the rear connector 17, but no front connector located on the front panel 18.

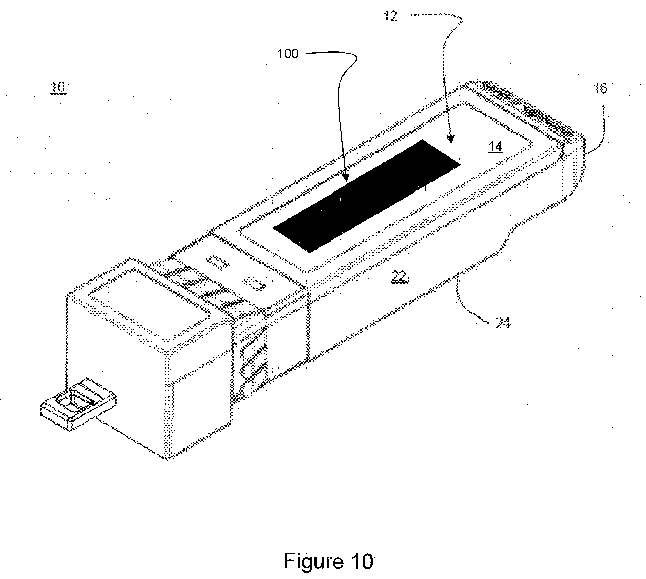

In the configuration (Figures 9 and 10) where the SFP unit 10 has no front connector located on the front panel 18, the front panel 18 may include components such as one or more led, a screen, etc.

The present disclosure is not limited to SFP units, but also applies to other types of standardized hot-pluggable transceiving units including the insert 100. Furthermore, the present disclosure is not limited to SFP units or other types of standardized hot-pluggable transceiving units comprising a housing with standardized dimensions. The present disclosure also applies to any transceiving unit including the insert 100 and adapted to being inserted into a chassis / a corresponding port of a hosting unit.

### TRANSCEIVING UNIT WITH A HEAT SINK FOR EXTRACTING HEAT

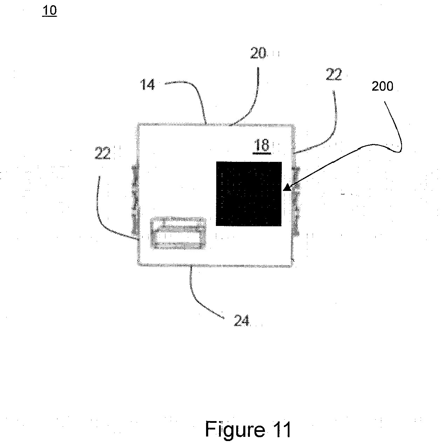

Referring now concurrently to Figures 11, 12A, 12B and 13, the SFP unit 10 of Figures 1-6 is represented with a heat sink 200.

The heat sink 200 is integrated to the front panel 18 of the housing 12. The role of the heat sink 200 is to extract heat generated by one or more electronic component located inside the housing 12. Heat sinks are well known in the art and can be designed to operate in the context of an SFP unit.

The one or more electronic component generates heat within the housing 12, and at least part of the generated heat is passively extracted from the housing 12 by the heat sink 200. The extracted heat is released by the heat sink 200 outside the housing 12. Examples of electronic component include an optical to electrical signal converter, an electrical to optical signal converter, a signal re-clocking unit, a signal processing unit, a data processing unit adapted for processing data transported by a signal, etc. The signal or data processing unit may consist of processor(s), Field-Programmable Gate Arrays (FPGA), Application-Specific Integrated Circuit (ASIC), etc.

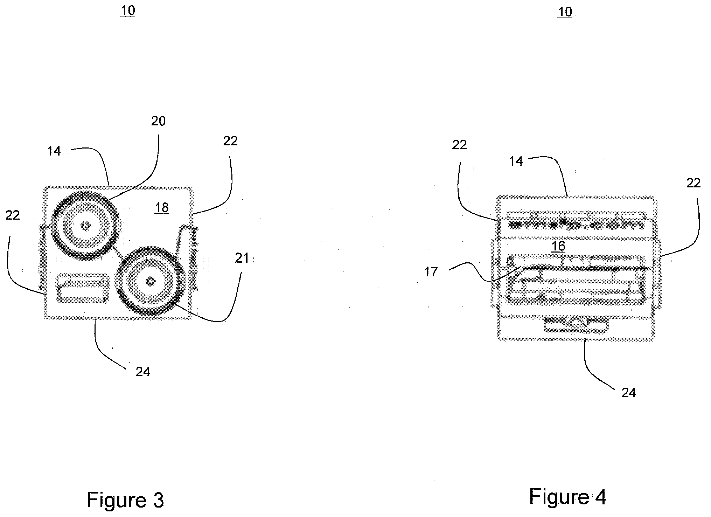

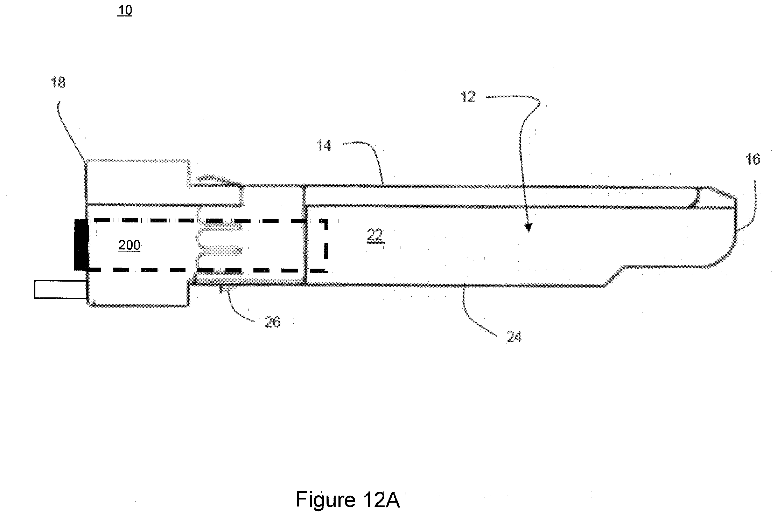

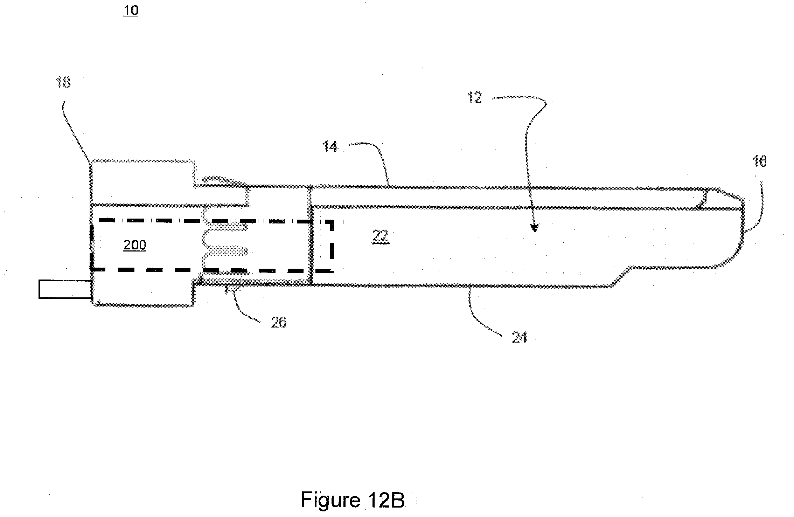

In a first exemplary implementation, the heat sink 200 is at least partially located inside the front panel 18 of the housing 12. A first end of the heat sink 200 extends within the housing 12, for collecting the heat generated by the one or more electronic component located inside the housing 12. A second end of the heat sink 200 extends outside the housing 12 through an opening in the front panel 18 of the housing 12, for evacuating the heat (generated by the one or more electronic component located inside the housing 12) in the environment outside the housing 12. Alternatively, the second end of the heat sink 200 does not extend outside the housing 12, but is in contact with the environment outside the housing 12 through an opening in the front panel 18 of the housing 12. The heat sink 200 is affixed to the front panel 18 and / or the rest of the housing 12 by means well known in the art (e.g. the heat sink 200 is welded to the front panel 18 and / or the rest of the housing 12, the heat sink 200 is held together with the front panel 18 and / or the rest of the housing 12 by fasteners or bonding, etc.). Figure 11 represents a front elevation view of the SFP unit 10 with the heat sink 200, corresponding to Figure 3. Figure 12A represents a side elevation view of the SFP unit 10 with the heat sink 200 extending outside the front panel 18, corresponding to Figure 2. Figure 12B represents a side elevation view of the SFP unit 10 with the heat sink 200 not extending outside the front panel 18, corresponding to Figure 2.

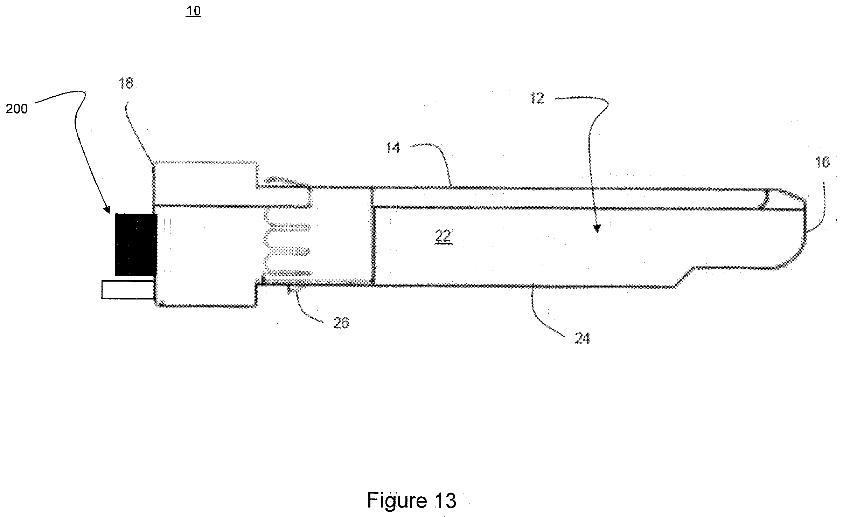

In a second exemplary implementation, the heat sink 200 is affixed to a surface of the front panel 18 external to the housing 12. The heat sink 200 is positioned along a portion of the external surface of the front panel 18 of the housing 12 and is located outside of the housing 12. The heat sink 200 is affixed to the front panel 18 of the housing 12 by means well known in the art (e.g. the heat sink 200 is welded to the front panel 18 of the housing 12, the heat sink 200 is held together with the front panel 18 of the housing 12 by fasteners or bonding, etc.). Heat generated by the one or more electronic component located inside the housing 12 is transmitted to the front panel 18 of the housing 12, extracted by the heat sink 200 and released in the environment outside the housing 12 through thermal contact between the heat sink 200 and the external surface of the front panel 18 of the housing 12. Figure 11 represents a front elevation view of the SFP unit 10 with the heat sink 200, corresponding to Figure 3. Figure 13 represents a side elevation view of the SFP unit 10 with the heat sink 200, corresponding to Figure 2.

In a third exemplary implementation, the heat sink 200 is a plug and play heat sink adapted for being inserted into a front connector (e.g. 20) located on the front panel 18 of the housing 12. When plugged into the front connector, the heat sink 200 is in thermal contact with the external surface of the front panel 18 of the housing 12. Heat generated by the one or more electronic component located inside the housing 12 is transmitted to the front panel 18 of the housing 12, extracted by the heat sink 200 and released in the environment outside the housing 12 through thermal contact between the heat sink 200 and the external surface of the front panel 18 of the housing 12. This implementation has not been represented in the Figures.

The representation of the heat sink 200 in the Figures is schematic for simplification purposes. The heat sink 200 may have various form factors (as is well known in the art) as long as the heat sink 200 is designed for being integrated to the front panel 18 of the housing 12.

Figures 11, 12A, 12B and 13 illustrate the SFP unit 10 comprising the rear connector 17, but no front connector located on the front panel 18. However, in a different configuration not represented in the Figures for simplification purposes, the SFP unit 10 comprises the rear connector 17, and at least one front connector (e.g. 20 and 21). The respective designs of the heat sink 200 and the at least one front connector are adapted for being concurrently supported by the front panel 18 of the housing 12.

In the configuration where the SFP unit 10 has no front connector located on the front panel 18, the front panel 18 may include components (in addition to the heatsink 200) such as one or more led, a screen, etc. Alternatively, the heat sink 200 occupies substantially the entire surface of the front panel 18.

In an alternative configurations, the heat sink 200 may be integrated to one of the back pane! 16, the top 14, the bottom 24, or one of the sides 21. Several heat sinks 200 may also be integrated to a combination of at least some of the front panel 18, the back panel 16, the top 14, the bottom 24, and at least one of the sides 21.

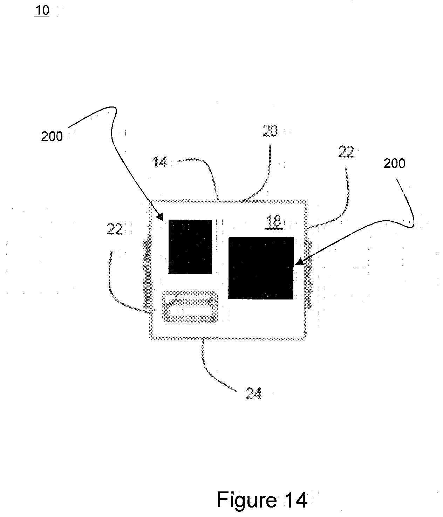

The SFP unit 10 may comprise more than one heat sink 200 integrated to the front panel 18 of the housing 12. For example, Figure 14 represents a front elevation view of the SFP unit 10 with two heat sinks 200, corresponding to Figure 3.

Optionally, the SFP unit 10 further comprises an active cooling device 300 located inside the housing 12. The active cooling device 300 aims at improving the efficiency of the heat sink 200 for extracting heat generated by the one or more electronic component located inside the housing 12.

Various types of active cooling devices may be used in the context of the present disclosure, such as for example a fan, a blower, a thermoelectric cooler, a heat pipe, etc. In a particular configuration, the active cooling device 300 is located in the vicinity of a surface of the front panel 18 internal to the housing 12.

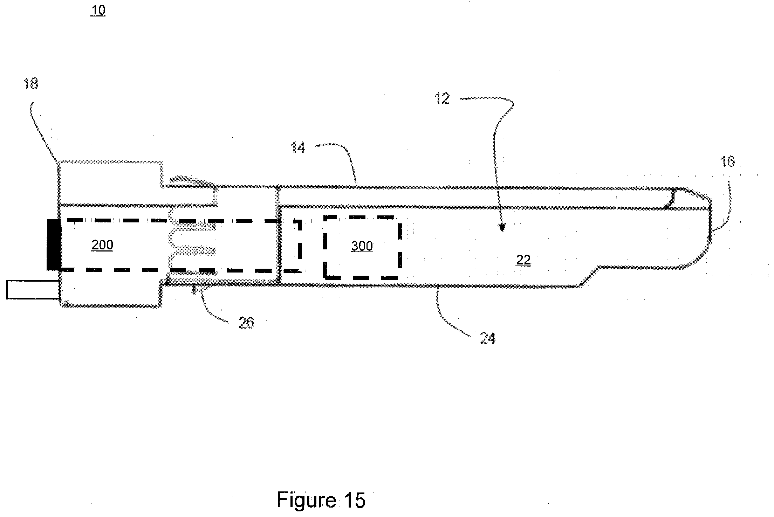

Figure 15 represents a side elevation view of the SFP unit 10 (corresponding to Figure 12A) with the heat sink 200 and an active cooling device 300 of the type fan, blower or thermoelectric cooler. In the case where the active cooling device 300 is a fan or a blower, it collaborates with the heat sink 200 by pushing heat generated by the one or more electronic component inside the housing 12 towards the heat sink 200; the heat sink 200 extracting the heat from the housing 12 and releasing the heat outside the housing 12 as previously described. In the case where the active cooling device 300 is a thermoelectric cooler, it complements the action of the heat sink 200 by absorbing some of the heat generated by the one or more electronic component inside the housing 12.

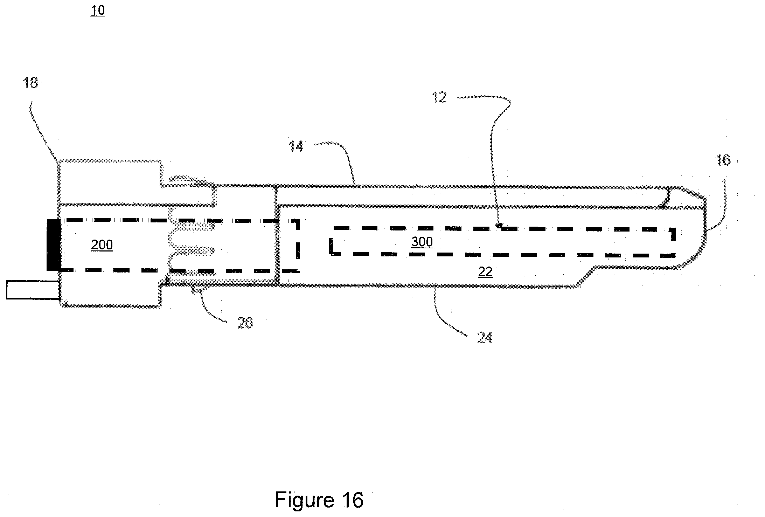

Figure 16 represents a side elevation view of the SFP unit 10 (corresponding to Figure 12A) with the heat sink 200 and an active cooling device 300 of the type heat pipe. The heat pipe 300 extends longitudinally within the housing 12. The heat pipe 300 collaborates with the heat sink 200 by absorbing heat generated by the one or more electronic component inside the housing 12 and releasing the absorbed heat in the vicinity of the heat sink 200; the heat sink 200 extracting the heat from the housing 12 and releasing the extracted heat outside the housing 12 as previously described.

Optionally, the SFP unit 10 further comprises the previously described insert 100.

Thus, the following implementations of the SFP unit 10 are considered by the current disclosure: the SFP unit 10 comprising the heat sink 200 only, the SFP unit 10 comprising the heat sink 200 and the cooling device 300, the SFP unit 10 comprising the heat sink 200 and the insert 100, the SFP unit 10 comprising the heat sink 200 and a combination of the cooling device 300 and the insert 100.

The present disclosure is not limited to SFP units, but also applies to other types of standardized hot-pluggable transceiving units including the heat sink 200. Furthermore, the present disclosure is not limited to SFP units or other types of standardized hot-pluggable transceiving units comprising a housing with standardized dimensions. The present disclosure also applies to any transceiving unit including the heat sink 200 and adapted to being inserted into a chassis / a corresponding port of a hosting unit.

As mentioned previously, the SFP unit 10 comprises at least one connector (e.g. the rear connector 17 and optionally front connector(s) 20) for receiving and transmitting signals, each signal transporting one or more flow of data. For example, the flow of data consists of an IP flow transporting a data content (e.g. a video content). The signals and optionally the transported flows of data are processed by the electronic component located inside the housing 12 of the SFP unit 10, as is well known in the art.

In a particular implementation, at least one of the front connectors is not adapted for receiving signals transporting IP flows. For example, one or more front connector (e.g. 20) is a Serial Digital Interface (SDI) connector adapted for receiving SDI signals transporting SDI video payloads. Other types of front connectors, such as a High-Definition Multimedia Interface (HDMI) video connector for receiving a HDMI signals transporting HDMI video payloads, may be used as well.

Although the present disclosure has been described hereinabove by way of non-restrictive, illustrative embodiments thereof, these embodiments may be modified at will within the scope of the appended claims without departing from the spirit and nature of the present disclosure.

## Claims

1. A transceiving unit comprising:
a housing adapted to being inserted into a chassis of a hosting unit, the housing defining a top surface;
at least one electronic component located inside the housing;
an insert disposed along the top surface of the housing, the insert passively extracting heat generated by the at least one electronic component located inside the housing; and
a rear connector located on a back panel of the housing.

2. The transceiving unit of claim 1, wherein the insert is made of copper, silver, graphite, gold, platinum, or an alloy of a combination thereof.

3. The transceiving unit of claim 1, wherein the insert is integral to the top surface of the housing.

4. The transceiving unit of claim 3, wherein the top surface of the housing is entirely made of the insert.

5. The transceiving unit of claim 1, wherein the insert is affixed above the top surface of the housing.

6. The transceiving unit of claim 1, wherein the transceiving unit is a standardized hot-pluggable transceiving unit and the housing has standardized dimensions.

7. The transceiving unit of claim 6, wherein the transceiving unit is a Small Form-factor Pluggable (SFP) unit.

8. The transceiving unit of claim 1, further comprising at least one front connector located on a front panel of the housing.

9. The transceiving unit of claim 1, comprising no front connector located on a front panel of the housing.

10. A transceiving unit comprising:
a housing adapted to being inserted into a chassis of a hosting unit, the housing comprising a front panel;
at least one electronic component located inside the housing;
a heat sink integrated to the front panel for passively extracting heat generated by the at least one electronic component located inside the housing; and
a rear connector located on a back panel of the housing.

11. The transceiving unit of claim 10, wherein the heat sink is at least partially located inside the front panel of the housing.

12. The transceiving unit of claim 10, wherein the heat sink is affixed to a surface of the front panel external to the housing.

13. The transceiving unit of claim 10, wherein the transceiving unit is a standardized hot-pluggable transceiving unit and the housing has standardized dimensions.

14. The transceiving unit of claim 13, wherein the transceiving unit is a Small Form-factor Pluggable (SFP) unit.

15. The transceiving unit of claim 10, comprising no front connector located on the front panel of the housing.
